(19) Europäisches Patentamt / European Patent Office / Office européen des brevets

(11) **EP 2 595 320 A1**

(12) **EUROPEAN PATENT APPLICATION**
published in accordance with Art. 153(4) EPC

(43) Date of publication:
**22.05.2013 Bulletin 2013/21**

(51) Int Cl.:
***H03M 13/27*** *(2006.01)*

(21) Application number: **11806403.9**

(86) International application number:
**PCT/JP2011/000091**

(22) Date of filing: **12.01.2011**

(87) International publication number:
**WO 2012/008066 (19.01.2012 Gazette 2012/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.07.2010 JP 2010158054**

(71) Applicant: **Panasonic Corporation**
**Kadoma-shi**
**Osaka 571-8501 (JP)**

(72) Inventor: **ISHII, Tatsuji**
**c/o Panasonic Corporation**
**Chuo-ku**
**Osaka 540-6207 (JP)**

(74) Representative: **Grünecker, Kinkeldey,**
**Stockmair & Schwanhäusser**
**Leopoldstrasse 4**
**80802 München (DE)**

(54) **DE-INTERLEAVING DEVICE AND METHOD, AND DATA TRANSMISSION SYSTEM AND METHOD**

(57)     An input data block having a variable length is, without an additional memory unit, de-interleaved by using a single memory. A de-interleaving device for de-interleaving an input data block interleaved by storing data of an original data block including RxC' portions (C' represents any divisor of R×C) of data in a matrix of R columns × C rows in row-major order and reading the data of the original data block in column-major order includes a memory (11) configured to store R×C portions of data, a write address generator (12) configured to generate write addresses based on a first incremental value, a read address generator (13) configured to generate read addresses other than other than (n×R)+1th read addresses based on the first incremental value and to generate the (n×R)+1th read addresses based on a second incremental value, and a memory interface (14) configured to successively read data from a read address and to successively write data of an input data block to a write address.

FIG.1

Printed by Jouve, 75001 PARIS (FR)

**Description**

TECHNICAL FIELD

The present invention relates to a data processing device, and particularly relates to a device and a method for de-interleaving an interleaved data block, and a data transmission system and a data transmission method for transmitting interleaved data and de-interleaving the received interleaved data.

BACKGROUND ART

Upon data transmission in, e.g., digital terrestrial broadcasting or wireless communication, a burst error may occur due to, e.g., pulse interference or fading. When the burst error occurs, error correction of received data in a receiver cannot be performed, resulting in, e.g., image degradation of broadcasting contents.

As a data transmission method effective for the burst error, an interleaving system has been employed. In the interleaving system, an interleaving device serving as a transmitter stores data of an original data block in a matrix in row-major order, and reads the data of the original data block in column-major order. In such a manner, the interleaving device generates interleaved data with the data of the original data block being rearranged. A de-interleaving device serving as a receiver receives the interleaved data block. In the de-interleaving device, data of the received data block is stored in a matrix in column-major order, and is read in row-major order. In such a manner, the original data block is restored with the data of the input data block being rearranged once again (see, e.g., Patent Document 1). Since the interleaved original data block is transmitted as described above, the burst error can be replaced with a random error by de-interleaving even if the burst error occurs during the data transmission. Thus, the error correction of received data in the receiver can be performed.

The interleaving system is applicable to a data block having a variable data block length. If the data block length is variable, the number of rows varies when data of the data block is stored in a matrix in row-major order upon interleaving processing. The de-interleaving device does not use some of the rows of the matrix depending on the length of the input data block. That is, generation of write addresses for the unused rows is skipped, and therefore the input data block having the variable length is de-interleaved based on a principle which is basically the same as that used for a data block having a fixed length.

CITATION LIST

PATENT DOCUMENT

PATENT DOCUMENT 1: Japanese Patent Publication No. 2004-147240

SUMMARY OF THE INVENTION

TECHNICAL PROBLEM

For de-interleaving of an input data block having a fixed length, every time data is read from a memory, received data may be written to the same address as that of the read data. Thus, writing of data of an input data block and reading of data of an input data block stored in the memory right before the writing can be performed by using a single memory. On the other hand, for de-interleaving of an input data block having a variable length, a data block from which data is read and a data block in which data is written may be different from each other in a block length. In particular, if the length of the data block in which data is written is longer, there is a possibility that data is overwritten to an address, data of which is not yet read. In order to avoid the data overwriting, two memories are alternately used such that data is written in one of the memories while data is read from the other memory. Alternatively, if a single memory is used to read and write data as in the de-interleaving of the input data block having the fixed length, it is necessary to provide a buffer configured to temporarily store data to be received within a period caused by skipping generation of write addresses for unused rows. However, in any of the foregoing cases, an additional memory unit such as the memory or the buffer is required, resulting in an increase in circuit area.

In view of the foregoing, the objective of the present invention is to provide a de-interleaving device and a de-interleaving method for de-interleaving, without an additional memory unit, an input data block having a variable length by using a single memory. In addition, the objective of the present invention is to provide a data transmission system including the de-interleaving device and a data transmission method.

SOLUTION TO THE PROBLEM

In order to solve the foregoing disadvantage, the following technique is implemented by the present invention. That is, a de-interleaving device for de-interleaving an input data block interleaved by storing data of an original data block including R × C' portions of data in a matrix of R columns × C rows in row-major order and reading the data of the original data block in column-major order to restore the original data block, C' representing any divisor of R × C, includes a memory configured to store R × C portions of data; a write address generator configured to generate, starting from an initial value, a write address of the memory for each input data block based on a first incremental value provided as a difference between the initial value and a c+1th write address for a first-previous input data block stored in the memory, c representing the number of rows when data of the first-previous input data block is stored in the matrix in row-major order; a read address generator configured to generate, starting from the initial value, a read address of the memory other than a (n × R)+1th read address for each input data block based on the first incremental value, and to generate the (n × R)+1th read address based on a second incremental value provided as a difference between the initial value and a second write address for a first-previous input data block stored in the memory, n being an integer of 0 or more; and a memory interface configured to successively read data from the read address generated by the read address generator, and to successively write data of the input data block to the write address generated by the write address generator.

A de-interleaving method for de-interleaving an input data block to restore an original data block by storing, in a memory, the input data block interleaved by storing data of the original data block including R × C' portions of data in a matrix of R columns × C rows in row-major order and reading the data of the original data block in column-major order, C' representing any divisor of R × C, includes generating a first incremental value provided as a difference between first and c+1th write addresses for a first-previous input data block stored in the memory, c representing the number of rows when data of the first-previous input data block is stored in the matrix in row-major order; generating a second incremental value provided as a difference between first and second write addresses for a first-previous input data block stored in the memory; generating, starting from an initial value, a write address of the memory for each input data block based on the first incremental value; generating, starting from the initial value, a read address of the memory other than a (n × R)+1th read address for each input data block based on the first incremental value, and generating the (n × R)+1th read address based on the second incremental value, n being an integer of 0 or more; and successively reading data from the generated read address, and successively writing data of an input data block to the generated write address.

According to the de-interleaving device or the de-interleaving method, write addresses are generated based on the first incremental value regardless of the length of an input data block. On the other hand, read addresses other than (n × R)+1th read addresses are generated based on the first incremental value, and the (n × R)+1th read addresses are generated based on the second incremental value. As long as the number C' of rows when data of an input data block is stored in a matrix of R columns × C rows in row-major order is one of divisors of R × C, a read address leads a write address at all times even if a data block for reading and a data block for writing are different from each other in a block length. That is, it is ensured that, after a read address is generated for any address of the memory and data is read, a write address having the same value is generated. Thus, generation of a write address is not necessarily skipped, and a buffer configured to temporarily store received data is not necessary.

A data transmission system or a data transmission method includes an interleaving device or an interleaving step for generating and transmitting a data block interleaved by storing data of an original data block including R × C' portions of data in a matrix of R columns × C rows in row-major order and reading the data of the original data block in column-major order, C' representing any divisor of R × C; and the foregoing de-interleaving device configured to receive the interleaved data block and to de-interleave the received data block to restore the original data block, or a step for de-interleaving, according to the foregoing de-interleaving method, the received data block to restore the original data block.

ADVANTAGES OF THE INVENTION

According to the present invention, an input data block having a variable length can be, without an additional memory unit, de-interleaved by using a single memory. Thus, a circuit area of the de-interleaving device can be decreased.

BRIEF DESCRIPTION OF THE DRAWINGS

[FIG. 1] FIG. 1 is a configuration diagram of a de-interleaving device of an embodiment of the present invention.
[FIG. 2] FIG. 2 is a configuration diagram of a de-interleaving device of a variation.
[FIG. 3] FIG. 3 is a schematic diagram illustrating a relationship between an original data block and an interleaved data block.

[FIG. 4] FIG. 4 is a schematic diagram illustrating generation of write addresses for storing a first input data block.

[FIG. 5] FIG. 5 is a schematic diagram illustrating generation of read addresses for de-interleaving the first input data block and generation of write addresses for storing a second input data block.

[FIG. 6] FIG. 6 is a schematic diagram illustrating generation of read addresses for de-interleaving the second input data block and generation of write addresses for storing a third input data block.

[FIG. 7] FIG. 7 is a schematic diagram illustrating generation of read addresses for de-interleaving the third input data block.

[FIG. 8] FIG. 8 is a configuration diagram of a data transmission system of the embodiment of the present invention.

DESCRIPTION OF EMBODIMENTS

(Embodiment of De-Interleaving Device)

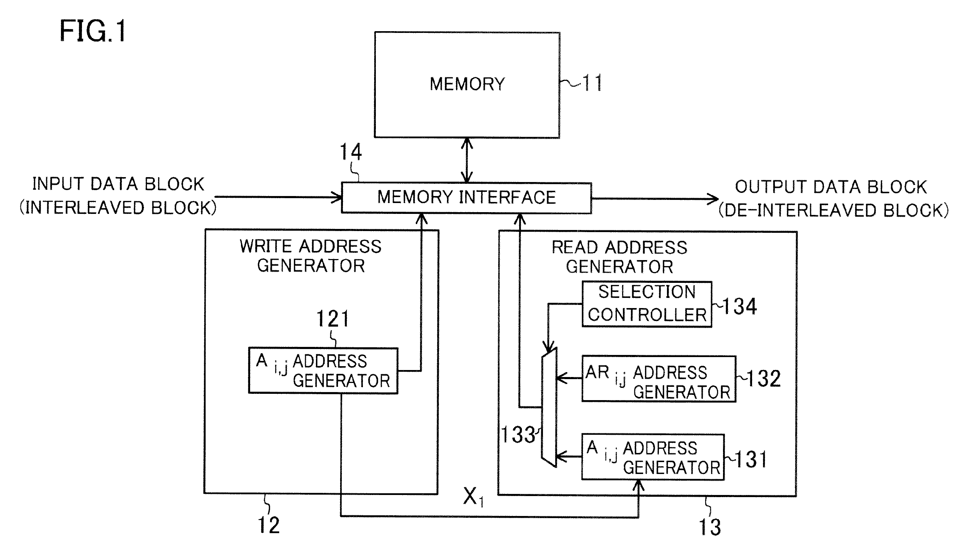

FIG. 1 illustrates a configuration of a de-interleaving device of an embodiment of the present invention. The de-interleaving device of the present embodiment is configured to de-interleave an interleaved input data block (i.e., an interleaved block) to generate an output data block (i.e., a de-interleaved block). For the sake of description, it is assumed that the input data block is a data block interleaved in such a manner that data stored in a matrix of R columns and C rows in row-major order is read in column-major order in an interleaving device which is not shown in the figure. In addition, it is assumed that the input data block is a variable-length data block satisfying a condition of Block Length = $R \times C'$ (where C' represents any divisor of $R \times C$).

In the de-interleaving device of the present embodiment, a memory 11 is configured to store M portions (where $M = R \times C$) of data. For the sake of simplicity, it is assumed that a memory address is specified by each of integers of "0" to "M - 1." A memory interface 14 successively reads data from read addresses of the memory 11 generated by a read address generator 13. Meanwhile, the memory interface 14 successively writes data of the input data block to write addresses of the memory 11 generated by a write address generator 12,

For each input data block, the write address generator 12 generates, starting from an initial value (e.g., "0"), write addresses of the memory 11 based on an incremental value $X_j$ which is provided as a difference between the initial value and a c+1th (where c is the number of rows when data of a first-previous input data block stored in the memory 11 is stored in a matrix of R columns $\times$ C rows in row-major order) write address of the first-previous input data block. Specifically, the write address generator 12 includes an address generator 121 configured to generate an address $A_{i,j}$, and supplies, as a write address, the address $A_{i,j}$ generated by the address generator 121 to the memory interface 14.

The address generator 121 generates the address $A_{i,j}$ according to a formula described below. In the formula, i represents an identification number of data of each input data block, and j represents an identification number of an input data block itself. In addition, $c_{j-1}$ represents the number of rows when data of a first-previous input data block is stored in a matrix of R columns $\times$ C rows in row-major order, and can be any divisor of R x C under the condition of Block Length = $R \times C'$. Note that i and j are generated by a counter which is not shown in the figure. For the sake of simplicity, it is assumed that each of i and j is an integer increasing from ''0'' by "1" in the order of entering the de-interleaving device.

[Formula 1]

$$A_{0,j}=0$$

$$A_{i,j}=(A_{i-1,j}+X_j) \quad \text{when} \quad A_{i-1,j} < M - X_j$$

$$A_{i,j}=(A_{i-1,j}-(M-X_j-1)) \quad \text{when} \quad A_{i-1,j} \geq M - X_j$$

$$\Biggr\} \text{for } i>0$$

where:

$$X_0=1$$

$$X_j=(X_{j-1} \cdot c_{j-1}) \bmod M + (X_{j-1} \cdot c_{j-1}) \mathrm{div}\, M \qquad \text{for } j>0$$

For each input data block, the read address generator 13 generates, starting from an initial value (e.g., "0"), read addresses of the memory 11 other than (n × R)+1th (where n is an integer of 0 or more) read addresses based on the incremental value $X_j$. The read address generator 13 generates the (n × R)+1th read addresses based on an incremental value $Y_j$ which is provided as a difference between the initial value and a second write address of a first-previous input data block stored in the memory 11. Specifically, the read address generator 13 includes an address generator 131 configured to generate an address $A_{i,j}$ based on the incremental value $X_j$, an address generator 132 configured to generate an address $AR_{i,j}$ based on the incremental value $Y_j$, a multiplexer 133 configured to selectively supply either one of the read addresses generated by the foregoing address generators to the memory interface 14, and a selection controller 134 configured to control the selection performed by the multiplexer 133.

The address generator 131 generates the address $A_{i,j}$ according to a formula described below. The formula is basically the same as that used for the address generator 121, except that not "1" but $X_1$ generated by the address generator 121 is used as $X_0$ and the address $A_{i,j}$ is renewed to the addresses $AR_{i,j}$ when (i mod R) = 0.

[Formula 2]

$$A_{0,j}=0$$

$$A_{i,j}=AR_{i,j} \quad \text{when} \quad (i \bmod R)=0$$

$$A_{i,j}=(A_{i-1,j}+X_j) \quad \text{when} \quad A_{i-1,j} < M - X_j$$

$$A_{i,j}=(A_{i-1,j}-(M-X_j-1)) \quad \text{when} \quad A_{i-1,j} \geq M - X_j$$

$$\Biggr\} \text{for } i>0$$

where:

$$X_0 = X_1 \text{ for Write Address}$$

$$X_j=(X_{j-1} \cdot c_j) \bmod M + (X_{j-1} \cdot c_j) \mathrm{div}\, M \qquad \text{for } j>0$$

The address generator 132 generates the addresses $AR_{i,j}$ according to a formula described below.

[Formula 3]

$$AR_{0,j}=0$$

$$AR_{i,j}=(AR_{i-R,j}+Y_j) \qquad \text{when} \quad AR_{i-R,j} < M-Y_j$$

$$AR_{i,j}=(AR_{i-R,j}-(M-Y_j-1)) \quad \text{when} \quad AR_{i-R,j} \geq M-Y_j \qquad \Bigg\} \text{ for } i > R$$

where:

$$Y_0=1$$

$$Y_j=(Y_{j-1} \cdot c_j) \bmod M+(Y_{j-1} \cdot c_j)\operatorname{div} M \qquad \text{for } j > 0$$

The selection controller 134 controls the selection performed by the multiplexer 133. Specifically, the selection controller 134 causes the multiplexer 133 to select the address generator 131 when (i mod R) ≠ 0 and to select the address generator 132 when (i mod R) = 0.

<Variation>

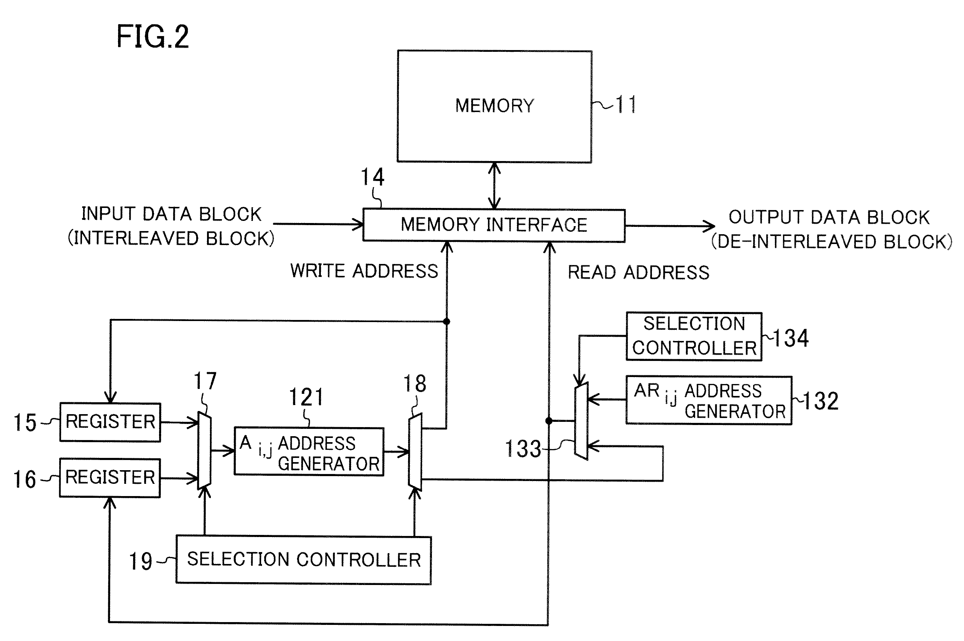

Since address generation criterions for the address generator 121 and the address generator 131 are substantially identical to each other, the write address generator 12 and the read address generator 13 may time-share a single address generator. For example, the address generator 131 may be omitted, and read addresses may be generated in the address generator 121. FIG. 2 illustrates a configuration of a de-interleaving device of such a variation. In order to allow generation of both of read and write addresses by the address generator 121, the de-interleaving device of the present variation includes a register 15 configured to store a first-previous write address, a register 16 configured to store a first-previous read address, a multiplexer 17 configured to selectively supply either one of the addresses stored in the registers to the address generator 121, a demultiplexer 18 configured to selectively supply, as either one of a read address or a write address, an address generated by the address generator 121 to the memory interface 14, and a selection controller 19 configured to control the selection performed by the multiplexer 17 and the demultiplexer 18.

An operation of the selection controller 19 is as follows. In the case of write address generation, the selection controller 19 causes the multiplexer 17 to select the register 15, and causes the demultiplexer 18 to output, as a write address, an address generated by the address generator 121. On the other hand, in the case of read address generation, the selection controller 19 causes the multiplexer 17 to select the register 16, and causes the demultiplexer 18 to output, as a read address, an address generated by the address generator 121.

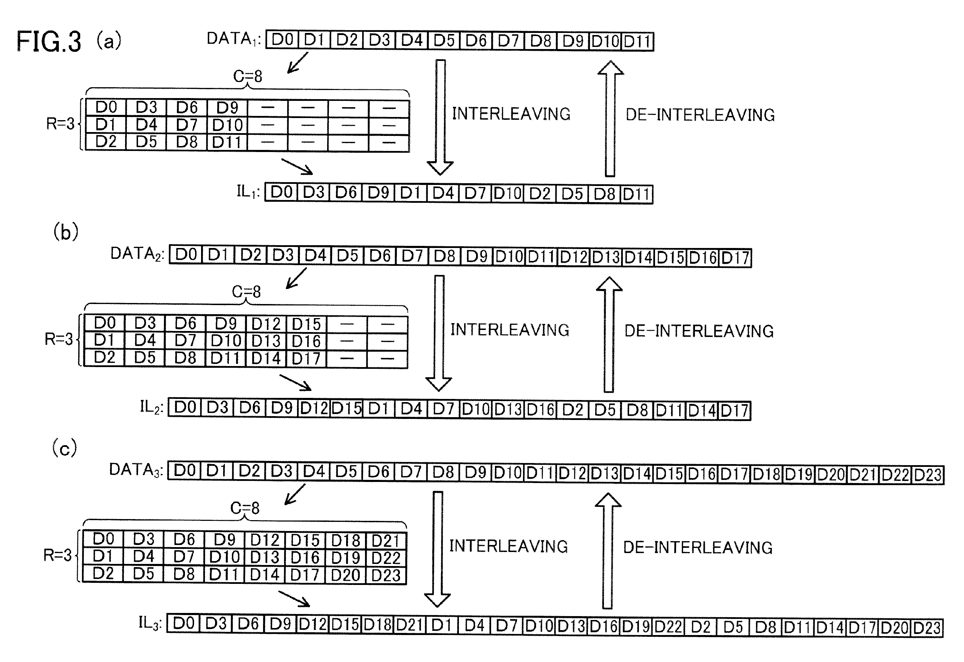

Next, de-interleaving processing by the de-interleaving device of the present embodiment will be described with a specific example. Referring to FIG. 3, data of an original data block is stored in a matrix of three columns × eight rows in row-major order, and is read in column-major order. In such a manner, an interleaved block is generated. The de-interleaving device de-interleaves such an interleaved block to restore the original data block. Each of a first original data block $DATA_1$ and an interleaved block $IL_1$ includes 12 data portions (= three columns × four rows), i.e., data D0-D11. Each of a second original data block $DATA_2$ and an interleaved block $IL_2$ includes 18 data portions (= three columns × six rows), i.e., data DO-D 17. Each of a third original data block $DATA_3$ and an interleaved block $IL_3$ includes 24 data portions (= three columns × eight rows), i.e., data D0-D23.

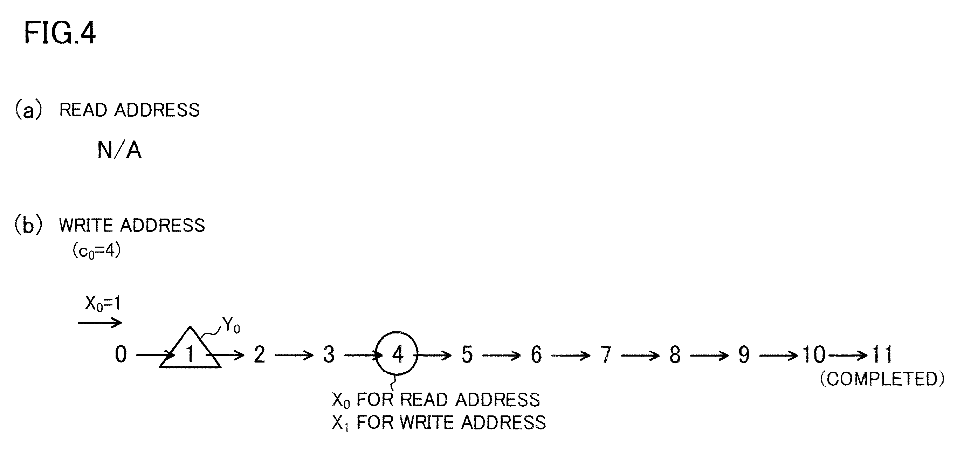

The de-interleaving device generates write addresses in the order indicated by solid arrows illustrated in FIG. 4, and stores the interleaved block $IL_1$ in the memory 11. That is, the write address is, starting from an initial value of "0," increased by $X_0 = 1$ upon the storage of the interleaved block $IL_1$. Since there is no data to be read at this point, read addresses are not applicable (N/A).

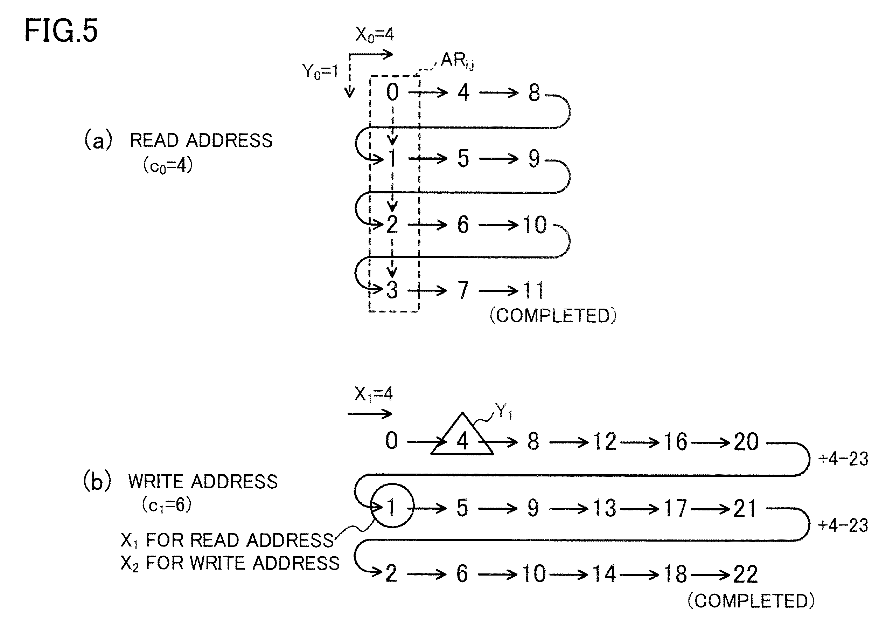

When the storage of the interleaved block $IL_1$ is completed, the de-interleaving device generates read addresses and write addresses in the order indicated by solid arrows illustrated in FIG. 5. Then, the de-interleaving device reads the interleaved block $IL_1$ from the memory 11 to de-interleave the interleaved block $IL_1$ while storing the interleaved block $IL_2$ in the memory 11. An incremental value $X_0$ for the read address generation and an incremental value $X_1$ for the write address generation are provided as a difference between the initial value and the fifth write address for the

interleaved block $IL_1$, and an incremental value $Y_0$ for the read address generation is provided as a difference between the initial value and the second write address for the interleaved block $IL_1$. Since the initial value is "0," the fifth write address of "4" for the interleaved block $IL_1$ is, without change, regarded as the incremental values $X_0$ and $X_1$, and the second write address of "1" for the interleaved block $IL_1$ is, without change, regarded as the incremental value $Y_0$ (see FIG. 5).

It should be noted that, if the write address is increased from the initial value of "0" by $X_0 = 4$ (if the write address reaches more than "24" by adding "4," "23" is subtracted from the write address), the read address is renewed to the addresses $AR_{i,j}$ every time three read addresses are generated. Thus, even if a data block for reading and a data block for writing are different from each other in a block length, a read address leads a write address at all times. Consequently, data is not overwritten to an address, data of which is not yet read, and a disadvantage relating to the overwriting of data is not caused. For example, when write addresses or "1," "5," and "9" are generated, data is already read from each of such addresses.

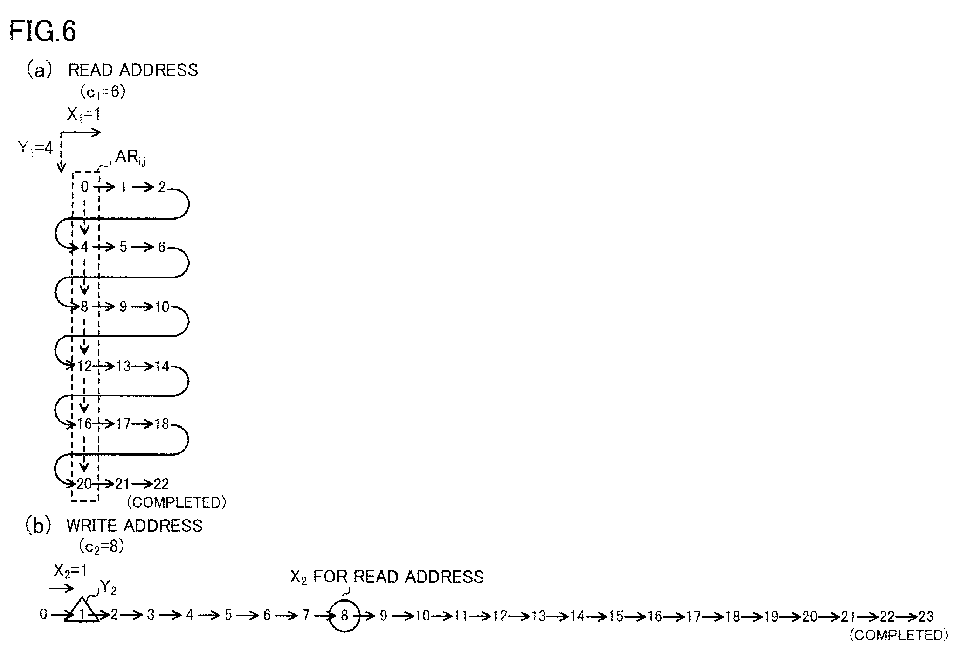

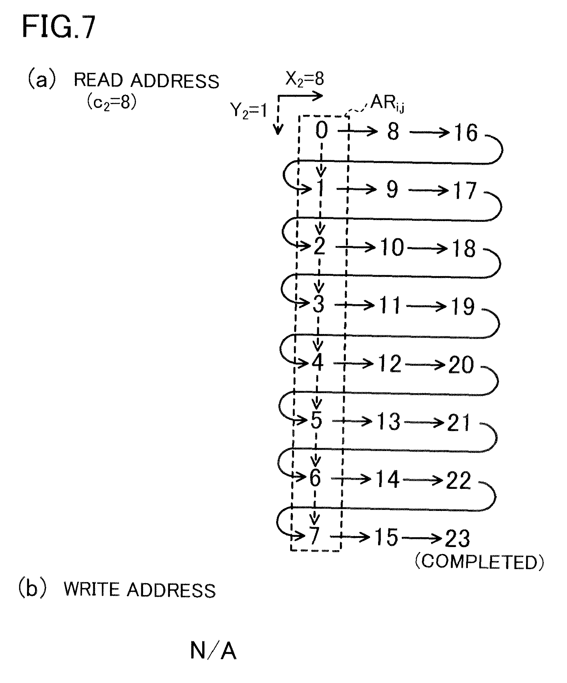

Similarly, when the de-interleaving of the interleaved block $IL_1$ is completed, the de-interleaving device generates read addresses and write addresses in the order indicated by solid arrows illustrated in FIG. 6. Then, the de-interleaving device reads the interleaved block $IL_2$ from the memory 11 to de-interleave the interleaved block $IL_2$ while storing the interleaved block $IL_3$ in the memory 11. The seventh write address of "1" for the interleaved block $IL_2$ is, without change, regarded as an incremental value $X_1$ for the read address generation and an incremental value $X_2$ for the write address generation, and the second write address of "4" for the interleaved block $IL_2$ is, without change, regarded as an incremental value $Y_1$ for the read address generation (see FIG. 5). When the de-interleaving of the interleaved block $IL_2$ is completed, the de-interleaving device generates read addresses in the order indicated by solid arrows illustrated in FIG. 7, and reads the interleaved block $IL_3$ from the memory 11 to de-interleave the interleaved block $IL_3$. The ninth write address of "8" for the interleaved block $IL_3$ is regarded as an incremental value $X_2$ for the read address generation, and the second write address of "1" for the interleaved block $IL_3$ is regarded as an incremental value $Y_2$ for the read address generation (see FIG. 6).

According to the present embodiment, an input data block having a variable length can be, without an additional memory unit such as a buffer, de-interleaved by using a single memory. Thus, a circuit area of the de-interleaving device can be decreased.

The write address generator 12 and the read address generator 13 can be implemented as software executed by a central processing unit (CPU) which is not shown in the figure. The write address generator 12 and the read address generator 13 can be also implemented as a lookup table from which pre-calculated addresses are, without calculating write addresses and read addresses point by point, read according to the length of an input data block and an identification number of data.

(Embodiment of Data Transmission System)

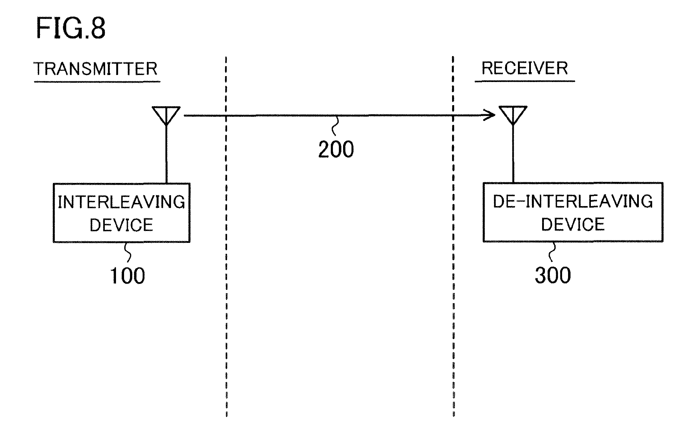

FIG. 8 illustrates a configuration of a data transmission system of the embodiment of the present invention. The data transmission system is, e.g., a digital terrestrial broadcasting system. An interleaving device 100 placed in, e.g., a broadcasting station as a transmitter stores data of a data block of broadcasting contents in a not-shown matrix of R columns $\times$ C rows in row-major order, and reads the data in column-major order. In such a manner, the original data block is interleaved. Note that the original data block includes R $\times$ C' portions (C' is any divisor of R $\times$ C) of data. The interleaved data block is broadcasted in the form of a terrestrial digital wave 200.

The foregoing de-interleaving device 300 is placed in, e.g., each house to be a receiver. The de-interleaving device 300 is mounted in, e.g., a terrestrial digital wave tuner. The de-interleaving device 300 obtains the interleaved block from the received terrestrial digital wave 200, and de-interleaves the interleaved block to restore the original data block. Then, after, e.g., error correction is performed for the restored original data block, the broadcasting contents are reproduced.

INDUSTRIAL APPLICABILITY

Since the de-interleaving device of the present invention can de-interleave, without an additional memory unit, an input data block having a variable length by using a single memory, the de-interleaving device of the present invention is useful for, e.g., a mobile terminal for which a reduction in size is required and which has a function to receive terrestrial digital broadcasting.

DESCRIPTION OF REFERENCE CHARACTERS

| 11 | Memory |
|---|---|
| 12 | Write Address Generator |
| 13 | Read Address Generator |
| 131 | Address Generator (First Address Generator) |
| 132 | Address Generator (Second Address Generator) |
| 133 | Multiplexer |
| 134 | Selection Controller |
| 14 | Memory Interface |
| 15 | Register (First Register) |
| 16 | Register (Second Register) |
| 17 | Multiplexer |
| 18 | Demultiplexer |
| 19 | Selection Controller |
| 100 | Interleaving Device |
| 300 | De-interleaving Device |

**Claims**

1.   A de-interleaving device for de-interleaving an input data block interleaved by storing data of an original data block including R $\times$ C' portions of data in a matrix of R columns $\times$ C rows in row-major order and reading the data of the original data block in column-major order to restore the original data block, C' representing any divisor of R $\times$ C, the de-interleaving device comprising:

a memory configured to store R $\times$ C portions of data;
a write address generator configured to generate, starting from an initial value, a write address of the memory for each input data block based on a first incremental value provided as a difference between the initial value and a write address for a first-previous input data block stored in the memory, c representing the number of rows when data of the first-previous input data block is stored in the matrix in row-major order;
a read address generator configured to generate, starting from the initial value, a read address of the memory other than a (n $\times$ R)+1th read address for each input data block based on the first incremental value, and to generate the (n $\times$ R)+1th read address based on a second incremental value provided as a difference between the initial value and a second write address for a first-previous input data block stored in the memory, n being an integer of 0 or more; and
a memory interface configured to successively read data from the read address generated by the read address generator, and to successively write data of the input data block to the write address generated by the write address generator.

2.   The de-interleaving device of claim 1, wherein
the read address generator includes

a first address generator configured to generate a read address based on a value obtained by adding the first incremental value to a first-previous read address,
a second address generator configured to generate a read address based on a value obtained by adding the second incremental value to a Rth-previous read address,
a multiplexer configured to selectively supply one of the read addresses generated by the first and second address generators to the memory interface, and
a selection controller configured to control selection performed by the multiplexer.

3.   The de-interleaving device of claim 1, further comprising:

a first register configured to store a first-previous write address;
a second register configured to store a first-previous read address;
an address generator time-shared by the write address generator and the read address generator and configured to generate an address based on a value obtained by adding the first incremental value to a given address;

a multiplexer configured to selectively supply one of addresses stored in the first and second registers to the address generator;

a demultiplexer configured to selectively supply, as one of a read address or a write address, an address generated by the address generator to the memory interface, and

a selection controller configured to control selection performed by the multiplexer and the demultiplexer.

4. A de-interleaving method for de-interleaving an input data block to restore an original data block by storing, in a memory, the input data block interleaved by storing data of the original data block including $R \times C'$ portions of data in a matrix of R columns $\times$ C rows in row-major order and reading the data of the original data block in column-major order, C' representing any divisor of $R \times C$, the method comprising:

generating a first incremental value provided as a difference between first and write addresses for a first-previous input data block stored in the memory, c representing the number of rows when data of the first-previous input data block is stored in the matrix in row-major order;

generating a second incremental value provided as a difference between first and second write addresses for a first-previous input data block stored in the memory;

generating, starting from an initial value, a write address of the memory for each input data block based on the first incremental value;

generating, starting from the initial value, a read address of the memory other than a $(n \times R)+1$th read address for each input data block based on the first incremental value, and generating the $(n \times R)+1$th read address based on the second incremental value, n being an integer of 0 or more; and

successively reading data from the generated read address, and successively writing data of an input data block to the generated write address.

5. A data transmission system comprising:

an interleaving device configured to generate and transmit a data block interleaved by storing data of an original data block including $R \times C'$ portions of data in a matrix of R columns $\times$ C rows in row-major order and reading the data of the original data block in column-major order, C' representing any divisor of $R \times C$; and

the de-interleaving device of claim 1 configured to receive the interleaved data block and to de-interleave the received data block to restore the original data block.

6. A data transmission method, comprising:

generating and transmitting a data block interleaved by storing data of an original data block including $R \times C'$ portions of data in a matrix of R columns $\times$ C rows in row-major order and reading the data of the original data block in column-major order, C' representing any divisor of $R \times C$; and

receiving the interleaved data block and de-interleaving, according to the method of claim 4, the received data block to restore the original data block.

# FIG.1

MEMORY ~11

14

INPUT DATA BLOCK
(INTERLEAVED BLOCK) → MEMORY INTERFACE → OUTPUT DATA BLOCK
(DE-INTERLEAVED BLOCK)

WRITE ADDRESS
GENERATOR

121

$A_{i,j}$ ADDRESS
GENERATOR

READ ADDRESS
GENERATOR

SELECTION
CONTROLLER ~134

$AR_{i,j}$ ADDRESS
GENERATOR ~132

133

$A_{i,j}$ ADDRESS
GENERATOR ~131

$X_1$

12                    13

EP 2 595 320 A1

## FIG.2

MEMORY ~11

14

INPUT DATA BLOCK
(INTERLEAVED BLOCK) → MEMORY INTERFACE → OUTPUT DATA BLOCK
(DE-INTERLEAVED BLOCK)

WRITE ADDRESS    READ ADDRESS

SELECTION
CONTROLLER ~134

17    121    18    AR $_{i,j}$ ADDRESS
GENERATOR ~132

15~ REGISTER    A $_{i,j}$ ADDRESS
GENERATOR    133~

16~ REGISTER

19~ SELECTION CONTROLLER

EP 2 595 320 A1

FIG.3 (a)

DATA₁: | D0 | D1 | D2 | D3 | D4 | D5 | D6 | D7 | D8 | D9 | D10 | D11 |

C=8

R=3

| D0 | D3 | D6 | D9 | — | — | — | — |
|----|----|----|----|---|---|---|---|
| D1 | D4 | D7 | D10 | — | — | — | — |
| D2 | D5 | D8 | D11 | — | — | — | — |

INTERLEAVING          DE-INTERLEAVING

IL₁: | D0 | D3 | D6 | D9 | D1 | D4 | D7 | D10 | D2 | D5 | D8 | D11 |

(b)

DATA₂: | D0 | D1 | D2 | D3 | D4 | D5 | D6 | D7 | D8 | D9 | D10 | D11 | D12 | D13 | D14 | D15 | D16 | D17 |

C=8

R=3

| D0 | D3 | D6 | D9 | D12 | D15 | — | — |
|----|----|----|----|-----|-----|---|---|
| D1 | D4 | D7 | D10 | D13 | D16 | — | — |
| D2 | D5 | D8 | D11 | D14 | D17 | — | — |

INTERLEAVING          DE-INTERLEAVING

IL₂: | D0 | D3 | D6 | D9 | D12 | D15 | D1 | D4 | D7 | D10 | D13 | D16 | D2 | D5 | D8 | D11 | D14 | D17 |

(c)

DATA₃: | D0 | D1 | D2 | D3 | D4 | D5 | D6 | D7 | D8 | D9 | D10 | D11 | D12 | D13 | D14 | D15 | D16 | D17 | D18 | D19 | D20 | D21 | D22 | D23 |

C=8

R=3

| D0 | D3 | D6 | D9 | D12 | D15 | D18 | D21 |
|----|----|----|----|-----|-----|-----|-----|
| D1 | D4 | D7 | D10 | D13 | D16 | D19 | D22 |
| D2 | D5 | D8 | D11 | D14 | D17 | D20 | D23 |

INTERLEAVING          DE-INTERLEAVING

IL₃: | D0 | D3 | D6 | D9 | D12 | D15 | D18 | D21 | D1 | D4 | D7 | D10 | D13 | D16 | D19 | D22 | D2 | D5 | D8 | D11 | D14 | D17 | D20 | D23 |

EP 2 595 320 A1

# FIG.4

(a) READ ADDRESS

$$N/A$$

(b) WRITE ADDRESS
$(c_0=4)$

$X_0=1$

$Y_0$

$0 \longrightarrow 1 \longrightarrow 2 \longrightarrow 3 \longrightarrow 4 \longrightarrow 5 \longrightarrow 6 \longrightarrow 7 \longrightarrow 8 \longrightarrow 9 \longrightarrow 10 \longrightarrow 11$

(COMPLETED)

$X_0$ FOR READ ADDRESS
$X_1$ FOR WRITE ADDRESS

EP 2 595 320 A1

# FIG.5

(a) READ ADDRESS
$(c_0=4)$

(COMPLETED)

(b) WRITE ADDRESS
$(c_1=6)$

$X_1$ FOR READ ADDRESS
$X_2$ FOR WRITE ADDRESS

(COMPLETED)

EP 2 595 320 A1

# FIG.6

(a) READ ADDRESS
    ($c_1=6$)

(COMPLETED)

(b) WRITE ADDRESS
    ($c_2=8$)

(COMPLETED)

# FIG.7

(a) READ ADDRESS
(c_2=8)

$X_2=8$

$Y_2=1$

$AR_{i,j}$

0 → 8 → 16

1 → 9 → 17

2 → 10 → 18

3 → 11 → 19

4 → 12 → 20

5 → 13 → 21

6 → 14 → 22

7 → 15 → 23
(COMPLETED)

(b) WRITE ADDRESS

N/A

# FIG.8

TRANSMITTER

RECEIVER

200

INTERLEAVING DEVICE

100

DE-INTERLEAVING DEVICE

300

## INTERNATIONAL SEARCH REPORT

| | International application No. |
|---|---|
| | PCT/JP2011/000091 |

| A. CLASSIFICATION OF SUBJECT MATTER |
|---|
| *H03M13/27(2006.01)i* |

According to International Patent Classification (IPC) or to both national classification and IPC

| B. FIELDS SEARCHED |
|---|

Minimum documentation searched (classification system followed by classification symbols)
H03M13/27

Documentation searched other than minimum documentation to the extent that such documents are included in the fields searched
Jitsuyo Shinan Koho          1922-1996   Jitsuyo Shinan Toroku Koho    1996-2011
Kokai Jitsuyo Shinan Koho    1971-2011   Toroku Jitsuyo Shinan Koho    1994-2011

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2006-094048 A (Toshiba Corp.), 06 April 2006 (06.04.2006), paragraphs [0041] to [0044], [0066] to [0079]; fig. 2, 7, 8 (Family: none) | 1-6 |
| A | JP 7-254862 A (Sony Corp.), 03 October 1995 (03.10.1995), paragraphs [0069] to [0076]; fig. 4 (Family: none) | 1-6 |
| A | JP 2006-101024 A (Hitachi Kokusai Electric Inc.), 13 April 2006 (13.04.2006), paragraphs [0049] to [0061]; fig. 6 to 8 (Family: none) | 1-6 |

☒ Further documents are listed in the continuation of Box C.        ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 January, 2011 (28.01.11) | 08 February, 2011 (08.02.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/000091

C (Continuation).    DOCUMENTS CONSIDERED TO BE RELEVANT

| Category* | Citation of document, with indication, where appropriate, of the relevant passages | Relevant to claim No. |
|---|---|---|
| A | Yun-Nan Chang, A Low-Cost Dual-Mode Deinterleaver Design, IEEE Transactions on Consumer Electronics, 2008.05, Vol.54, No.2 | 1-6 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004147240 A